(19) Europäisches Patentamt
European Patent Office
Office européen des brevets

(11) EP 0 464 808 B1

# (12) EUROPEAN PATENT SPECIFICATION

(45) Date of publication and mention
of the grant of the patent:
**22.05.1996 Bulletin 1996/21**

(51) Int Cl.6: **H04N 5/21**

(21) Application number: **91111068.2**

(22) Date of filing: **04.07.1991**

(54) **System for ghost compensation in video signals**

System zur Geisterbildkompensierung in Videosignalen

Système pour la compensation d'image fantôme dans des signaux vidéo

(84) Designated Contracting States:
**DE ES FR GB NL**

(30) Priority: **06.07.1990 IT 6750390**

(43) Date of publication of application:
**08.01.1992 Bulletin 1992/02**

(73) Proprietor: **EDICO S.r.l.**
**I-00197 Roma (IT)**

(72) Inventor: **Dal Poz, Stefano**
**I-32014 Ponte nelle Alpi, (Belluno) (IT)**

(74) Representative: **Notaro, Giancarlo et al**
**Buzzi, Notaro & Antonielli d'Oulx**
**Corso Fiume 6**
**I-10133 Torino (IT)**

(56) References cited:
• **BETTER VIDEO IMAGES,23RD ANNUAL SMPTE TELEVISION CONFERENCE,San Francisco,US; 3-4 February 1989;M.PAZARCI:"Reduction of multipath effects and channel distortion in broadcast television",p.128-135; SMPTE,White Plains,US**

**Description**

The present invention relates to an improved system for ghost compensation in video signals comprising at least one digital FIR and IIR filter, respectively.

It is known the deleterious visible side effects brought about the video signal caused by the ghost effect (note for example; J.M.Corbett and J.W.Allnatt "Subjective quality of television impared by short delay echo", IEEE Proc. vol. 121, N° 7, July 1974; and A.M.Lessman, "The subjective effect of echoes in 525 monochrome and NTSC colour televion and the resulting echo time waiting", Journal of SMPTE, vol.81, December 1972).

Such effects come about, be it from a simple variation of amplitude, of varying polarity and length, or from a more complex mixing of the video signals; with this in mind, the degradation of the PAL colour in certain ghosts situations can be particularly damaging.

The most insidious source of echoes of irradiated signals on terrestrial radio links is the well known multipath propagation caused by the reflexions of the signal against natural or artificial objects (mountains, tower blocks, etc.); in certain cases there are also temporary effects, as an example, situations caused by airplane flutter, especially noted in the vicinity of airports.

Another source of reflexions derives from the use of unmatched aerials, that in theory can easily be remedied with an accurate installation, though in practice this is often not the case. The

problem has gradually become worse with the increase of television transmitters, the constant building of tower blocks, the often incorrect installation of television aerials, and other causes; furthermore with the nearing of. high definition transmissions the problem becomes more acute, as the ghost effect is considerably enhanced in a signal having a shorter duration of line.

The digital elaboration of signals presents a fine instrument for minimizing the defects arising from spurious ghosts; infact various proposals have been made concerning systems that cancel or weaken the ghosts in a video signal; for example:

(1-) W. Ciciora et al., "A tutorial on ghost cancelling in television issystems", IEEE trans. on C.E., vol. 25, Feb.1979;
(2-) M.G.Larimore et al., "SHARF: an algorithm for adapting IIR digital filters", IEEE Trans. on ASSP, vol. 28, Aug. 1980;
(3-) T.H.S.Chao, "Multi-path equalization for NTSC video by using digital I.I.R. filter", IEEE Trans. on C.E., vol. 34, Feb. 1988
(4-) M.Pazarci, "An adptive ghost processor for broadcast television", IEEE Trans. on C.E., vol. 35 Aug. 1989.
(5-) M. Pazarci, "Reduction of Multipath effects and Channel Distortion in Broadcast Television", 23rd annual SMPTE Television Conference, San Francisco, 1989.

In (1) a panorama is made of all that is possible with the use of transversal filters; in (3) and (4) we can trace the algorithms by making use of filters only of the I.I.R, type (Infinite Impulse Response), that within the ambit of the prospected solutions require an elevated number of coefficients and are subject to instability; the algorithm proposed in (4) maintains the stability characteristics (see 2) at the price of arduous and uneasily identifyable calculations; in all of the cited articles the initial conditions of the unmatched signals do not take into account the composite unmatching deriving from the uncertainty of the carrier extracted from the intermediate frequence signal (note formula 6 below).

In (5) an adaptive recursive technique for removal of "ghosts" is described; three operating modes (0, 1, 2) are foreseen; mode 0 provides for linear updating of the coefficients; mode 1 provides for non-linear minimax windowing in updating; in mode 2 the algorithm is reduced to the real mode operation.

It results that the known systems require filters with an elevated number of coefficients, presenting dangers of instability, not realizing an elevated level of compensation; furthermore, they are not versatile, that is not adapt to all practical cases, that can be defined as:

a) demodulated signal from radio frequency on a domestic television set; in such a case, unfortunately it is impossible to recuperate the component in quadrature;
b) demodulated signal from radio frequency on professional apparatus, in which said recuperation is possible;
c) signal in a television studio, in particular high definition signals.

The object of the present invention is to produce an improved system of ghost compensation in video signals that is versatile, of an easy concrete realisation and of good performance.

According to the present invention the problem is solved by the features of claim 1.

Further aims and advantages of the present invention will become clear from the following detailed description and annexed drawings, supplied as a non limiting example, wherein:

figure 1 represents a block diagram of a circuitry model for ghost evaluation and of the relative compensation system;

figure 2 represents the behaviour of a filter useful for the solution of the problem;

figure 3 represents a model of multipath canal;

figure 4 represents a compensation system for the model of figure 3;

figure 5 represents a block diagram of the compensation apparatus according to the invention;

figure 6 represents a detailed circuit of a first part of the diagram of figure 5;

figure 7 represents a detailed circuit of a second part of the diagram of figure 5;

figure 8 represents in more detail a part of the circuit of figures 6 and 7.

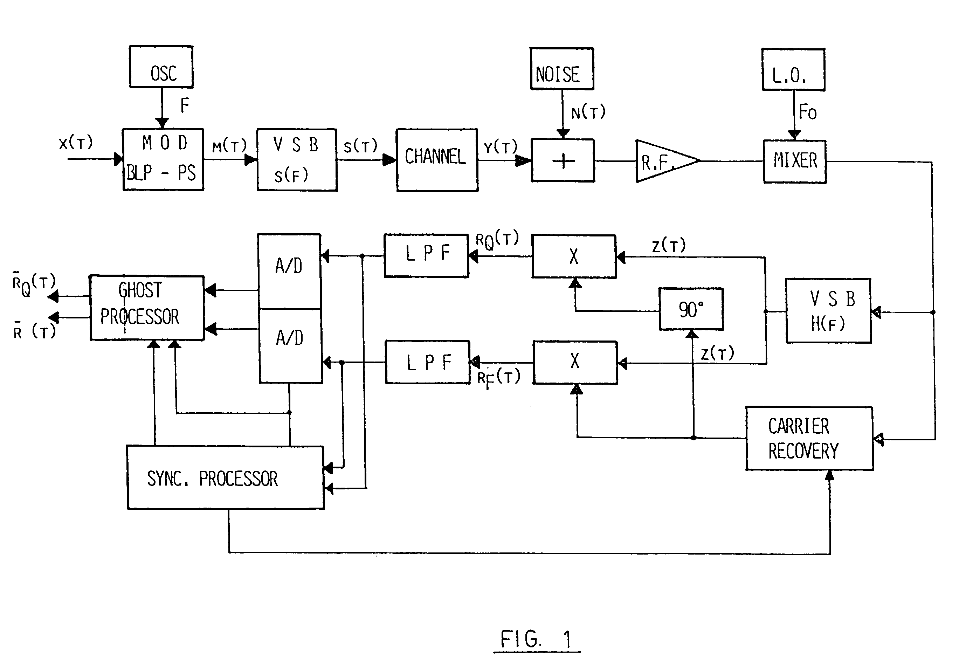

Figure 1, schematically represents as an example a circuitry model for ghost valuation.

A multipath canal can be described through an impulsive response of the type:

$$(1) \quad c(t) = \Sigma k \, ak \, \sigma \, (t\text{-}Tk) \, (k = 0, 1, ..., n)$$

where ak and Tk are respectively the relative gain (complex) of each path and the relative delay; $\sigma$ (t) is the Dirac impulse function.

If we assume $T_o = 0$ in (1) the case in which the principle path in its turn is attenuated is included.

If m(t) is the modulated signal and x(t) is the modulating signal, with reference to fig. 1, the relation is true:

$$(2) \quad m(t) = x(t) \cos(2\pi Ft + \beta)$$

where $\beta$ is the phase of the modulator and F the radio frequency carrier.

The signal transmitted is however a filtered version of (2) in which part of a lateral band is suppressed and only the vestigial version of m (t) results to be transmitted; the general expression of this signal is given from:

$$(3) \quad s(t) = m(t) * g(t)$$

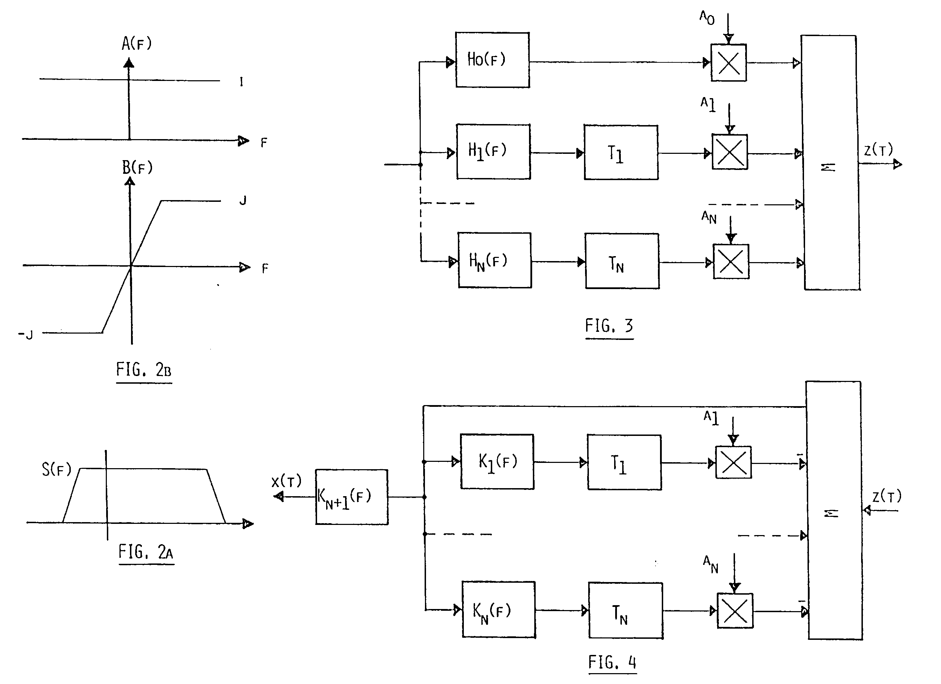

where the filter g(t) is described in the frequency domain as in fig. 2a and the operator $*$ is the convolution.

After filtering in reception and in absense of ghosts, the signal z (t) would be given as:

$$z(t) = n(t) \cos(2\pi Ft + \beta) - n*(t) \sin(2\pi Ft + \beta).$$

The signal $n*(t) = n(t) * b(t)$ is a pseudo transform of Hilbert of n(t) adding b(t) part of the reception filter $h(t) = a(t) + jb(t)$ described in -fig. 2b usually in the domain of the frequency.

As, based on (1), the filtered signal from the channel is

$$(4) \quad y(t) = \Sigma k \, ak \, s(t\text{-}Tk) \, (k = 0, 1, ..., n)$$

the complete expression of the signal downstream of the conversion towards the bottom (that is supposedly transparent) between the RF stage and the FI stage and of the complex reception filter results as follows:

$$(5) \quad z(t) = \Sigma k \, ak \, (x(t\text{-}Tk) \cos(2\pi F°t + \beta + 0k) + $$
$$+ x*(y\text{-}Tk) \sin(2\pi F°t + \beta + 0k))$$

where F° is the F.I carrier and $Ok = 2 F°Tk$ is the phase in which every single echo becomes demodulated due to the propogation delay.

Ideal synchronous demodulator receivers, on the contrary those of modulation envelope, do not introduce quadrature distortion thanks to the exact recovery of the carrier phase. Above all the presence of the Ok termins allows this true situation only in the case in which Ok = k i.e. only for particular values of Tk.

The expression for the riconstructed carrier is, in the general case,

$$(6) \quad p(t) = \Sigma k \cos(2\pi F°t + \beta + 2 F°Tk) \, (k = 0, 1, ..., n)$$

which may be rewritten as

$$(7) \quad p(t) = \cos(2\pi F°t + \beta + §)$$

with § equal to the global phase error in the reconstruction of the carrier deriving from the sole presence of the n reflexed carriers.

It shall be noted that in (7), for simplicity sake, the effects caused by the non ideal behaviour of the carrier reconstructor have been neglected as they may be supposedly compensated with an automatic control upon themselves.

The received signal r(t) is divided into a part of the signal "in phase" and a part of the signal "in quadrature":

$$(8) \quad rf(t) = Re \, (z(t) \, e**\text{-}j(\beta+§))$$
$$= x(t) \cos(§) + \Sigma k \, ak \, x(t\text{-}Tk) \cos(Ok+§) + $$
$$+ X(t) \sin(§) + \Sigma k \, ak \, x(t\text{-}Tk) \sin(Ok+§)$$
$$(9) \quad rq(t) = Im \, (z(t) \, e**\text{-}j(\beta+§))$$
$$= x(t) \, Sin(§) + \Sigma k \, ak \, x(t\text{-}Tk) \sin(Ok+§) + $$
$$+ X(t) \cos(§) + \Sigma k \, ak \, x(t\text{-}Tk) \cos(Ok+§)$$

where the cross interferences between signals in phase and signals in quadrature are evident.

The complessive model of deghosting is represented in figure 3, where

$$H(f) = A(f) \cos(§ + \beta k) + Bf \sin(§ + \beta k)$$

and

$$H(f) = \Sigma k\ Hk(f).$$

Figure 4 represents a compensation system for the pattern of figure 3. The invention assumes that only a limited number of ghosts are effectively responsable for the major defects: infact it estimates that it is very rare to have more than three ghosts of relevant importance.

With this assumption the algorithm that deghosts the signal determines the estimation aj, Tj, bi(k) (j=o,..., n; i=i,..., n+1), aj and Tj being the quantities indicated in figure 4, and bi(k) the coefficients of the filters ki(f).

The estimation is carried out by using an algorithm such as MSE and/or ZF applied to the sole lines containing appropriate test signals (and in particular ITS) and is carried out by comparing the test signal with the sole $r_F(t)$ or the pair fF(t), $r_a(t)$ where available.

The ITS signals (Insertion Test Signal) are present in several lines of the conventional irradiated PAL signal, based on the Recommendation 473 of C.C.I.R. (Dubrovnik, 1986).

There is no existing equivalent in the field of high definition signal irradiation: a similar type signal could be inserted in studio as an auxillary signal with the sole purpose of deghosting the out going signal; however any kind of run-in type sequence present in the given channel can be of help.

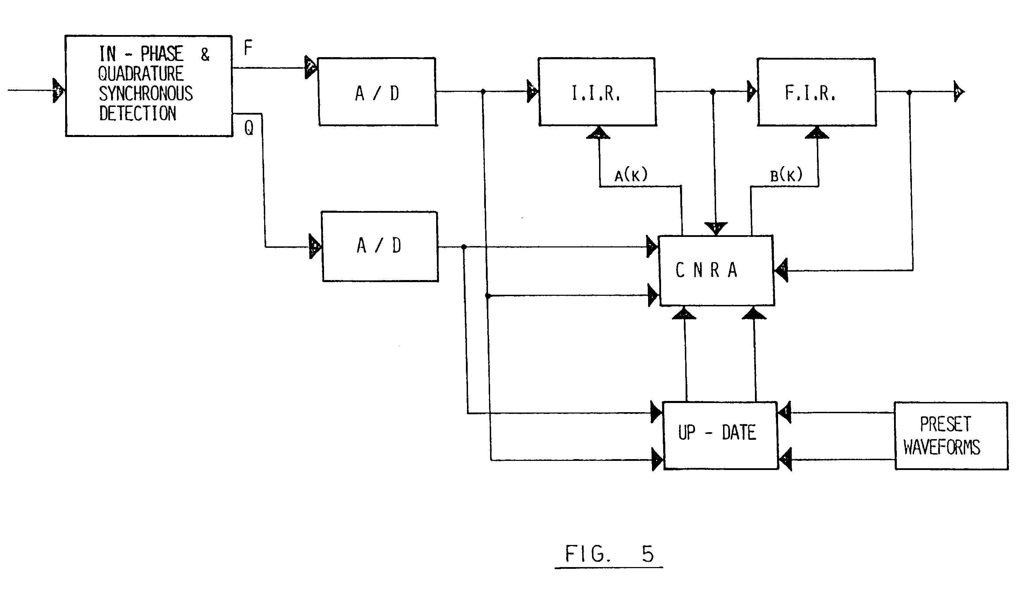

Given as an example, without questioning the validity of the novelty principles inherent in the invention, the circuit of figure 5 implements the diagram of figure 4, where $K_1(f) = ... K_n(f) = 1$ and where $K_{n+1}(f) = 1$: $(H_o(f))$ and n = 3.

The algorithm provides a control of the adaptability of the coefficients so as to avoid the points of singularity possibly present in the return branch, that in practice creates a filter of the I.I.R. type of three poles (see fig. 5).

The direct branch realizes an F.I.R type filter (Finite Impulse Response).

A further important control carries out a search, at pre-fixed intervals (arranged in a third of a line for the PAL systems and therefore able to resist ghosts of approximately 21 microseconds), on all the internal coefficients so as to select the three most intense ghosts present.

Whilst in the "running" mode the complessive filter operates on three + three coefficients (F.I.R. + I.I.R.), whereas in the "slow" mode it operates on all the coefficients of the interval.

In such a way a slow updating of all the coefficients occurs and there is the possibility to adapt to new situations (channel change, airplane flutter, etc.), whilst maintaining a notable simplification of the hardware of the "running" mode, and a consequent rapid operation.

In simulation it has been varified that the "slow" mode reaches the regime from an initial condition completely unmatched (filter passes everything) in less than two seconds.

Possible deghosting applications regard:

a) Demodulated signal from R.F: on consumer appliances;
b) Demodulated signal from R.F. on professional apparatus;
c) High definition signal in television studios.

The block diagram of the apparatus as described is given in figure 5. In case a) the relations (8) and (9) are composed of all their terms, but signal (9) is not available as only the in phase signal is supplied. In this case the proposed algorithm does not deghost the in-coming signal perfectly, but the reduction of the presence of natural echoes induced by signals in quadrature is however considerable. In case b), if it is possible to recover the signal in quadrature from a professional apparatus, the experiments conferm as stated in the theory, i.e. that the signal x(t) can be recovered without errors; it remains understood that in a finished arithmetical system as is a real apparatus, this is achieved by submitting to the reductions of the effect of quantization and of the propagation of such error.

Case c), foresees the use of this algorithm for the deghosting of high definition signals produced in a television studio and directed in base band on coaxial cables and for the various post-productive phases.

The production of unintentional echoes of the type (8) and (9) appears inevitable, where obviously the only terms present are those deriving from the physical in phase reflextions (the terms relative to the third lines of (8) and (9) are therefore absent).

As it is easy to perceive the effect of echoes on high definition signals it is more deleterious as the line time results in being reduced with respect the norm, but its preventive deghosting can greatly improve the quality.

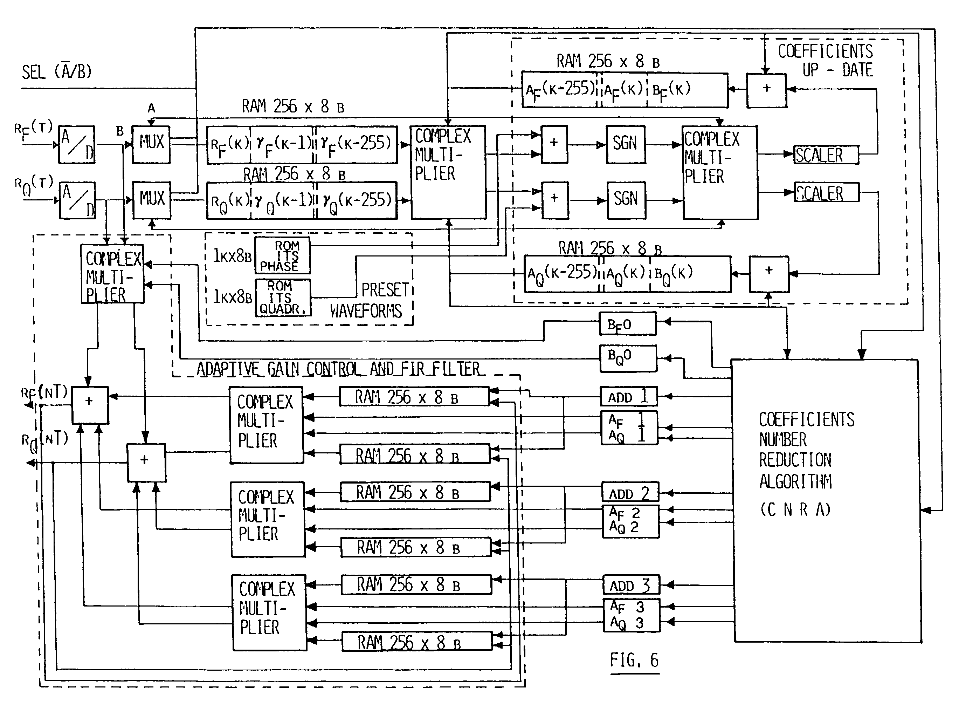

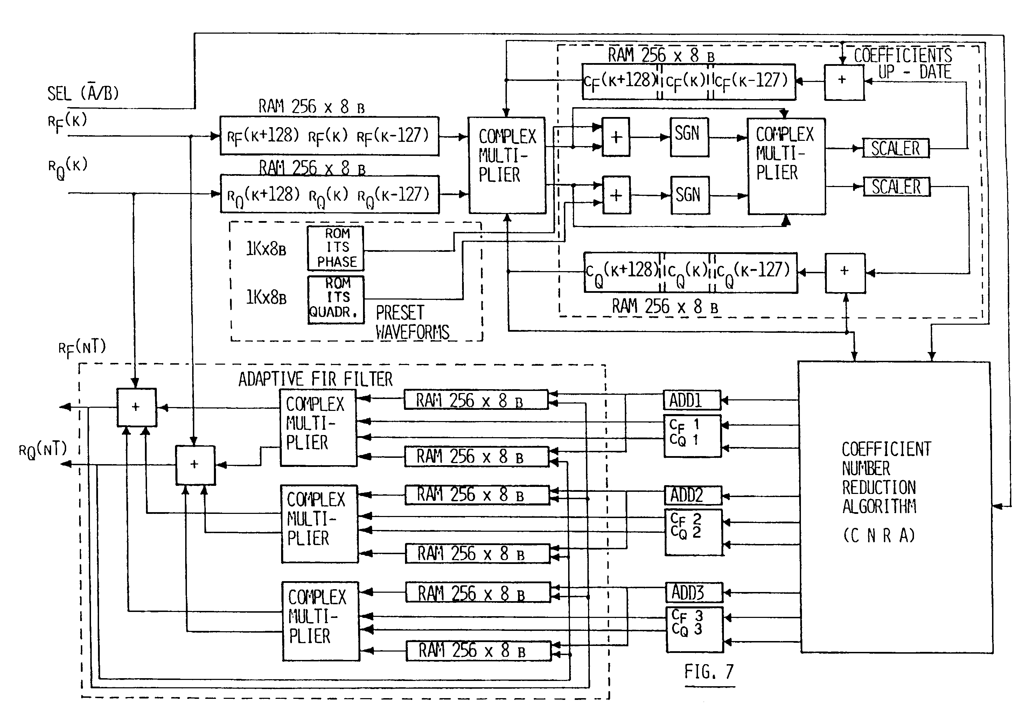

Figures 6 and 7 present an example of parts of the proposed deghosting circuit, from the block diagram of figure 5, realisable utilizing commercial devices.

The diagram of figure 6 corresponds to the part of the circuit containing the I.I.R. filter; the diagram of figure 7 corresponds to the part of the circuit containing the F.I.R. filter; said circuit is the same for the three abovementioned cases a), b) and c), however for case c) the diagram is appropriately simplified, whereas case a) requires an additional filter.

For case b), that is of demodulated PAL or NTSC signals on professional apparatus, with the availability of in phase signal and signal in quadrature, the diagram of figure 6 is sufficient to the complete functioning description.

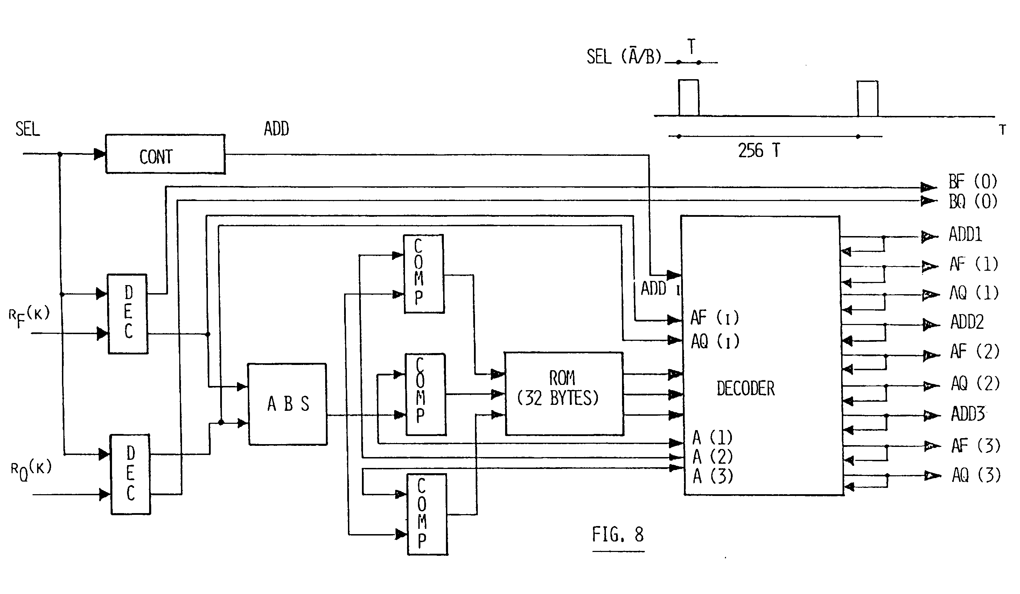

The signal, in its in phase and in quadrature components, becomes digitalised and it divides in two fluxes. The first (superior section of figure 6) is multiplexed with the filtered signal with the timing shown at the top of figure 8, subsequently the results are utilized for updating the values of all the coefficients (256). The second flux (inferior section of figure 6) utilizes the reduction algorithm of the number of coefficients (C.N.R.A. Coefficient Number Reduction Algorithm) so as to operate in real time the true I.I.R. complex adaptive filtering.

The first block designated "Complex Multiplier" met by said second flux is responsible for gaining control of the zero delay coefficient (one tap F.I.R.) necessary when the principle signal also presents an abnormal attenuation.

The diagram of figure 7 is analogous of that of figure 6; the complex multiplexers of figures 6 and 7 may be of the PDSP 16112A type produced by Plessey. The block for the reduction of the number of coefficients, is described in figure 8 and works "off-line"; it accepts in sequence all the coefficients, distinguishing the Bf/q coefficients from the 5 Af/q coefficients, comparing the modulu~ of each coefficient A(i) entered with the three major coefficients at that time found A(1),A(2) and A(3) and returning the new ordered sequence A(1), A(2) and A(3) in output. The memory's addresses are calculated based on the input signal SEL.

The signal B(O), always calculated based on SEL, is restored in output without the need of any particular calculations. Another positive function of the C.N.R.A. block is that of controlling the I.I.R. filter: if the ammount of coefficient moduli A(i) results in being minor to the coefficient module B(O), preset to 1, each A(i) is scaled of an appropriate quantity; in such a way that the stability of the filter is absolute, with the exception of the case, estimated at being very rare, in which the energy of the global signal is distributed more on the ghosted signals than on the useful signal. In case c) (signals on high definition cables), figure 6 results in being redundant; infact the complex branch, deriving from a demodulation is absent and the complete circuit of figure 6 is utilised eliminating the relative circuitry of the complex part of the signal. It is obvious that so as to be able to obtain deghosting of a high definition signal it is necessary to apply the diagram as indicated to each of the components of the global signal (R,G,B or Y,U,V). In case a) (demodulated conventional signals in the sole in phase signal) the usage of the sole in phase signal (therefore of the sole branch F) does not permit the elimination of all ghosts therefore it becomes necessary an ulterior adaptive F.I.R. filter (see figure 7)

The principle diagram and the complexity are more or less identical to those of the previous diagram.

The realisation of a single A.S.I.C., that in appearance is possible, would be highly recommendable for the compactness and for the possibility of increasing the internal precision.

The characteristics of the described device become clear from the effected description and annexed drawings.

From the effected description the advantages of the device of echo compensation object of the present invention also become clear.

In particular these are represented by the following.

First of all the deghosting quality results in being very elevated, as is the versitility of application of different video formats.

With applied video signal, noise affected, have shown a marked improvement of the report S/N, even over 40 dB in cases a) and c); has been measured in case a) good results have been obtained by applying the above philosophy with different types of filtering.

The effective adaptability of the system that is able to pursue, with very brief reply times, even large variations of inappropriate conditions of the entrance signal is to be taken into consideration.

The saving of components is also notable, discreet or integrated, of the filters realisable thanks to the particular strategy adopted of reducing the coefficients of the actual filters; such savings allow for a further interesting possibility of choice, starting from stored samples, between a more extensive interval of deghosting and the possibility of eliminating fractionary echoes. If the algorithm is implemented on the logic that supports high speed, it is possible to validly resist the presence of echoes whose delay does not coincide with a multiple interval of sampling at the sacrifice of the range within which the deghoster guarantees the locking of the algorithm.

In particular this is the case of high definition signals distributed in a television studio, for which it is reasonable to imagine that the delays are not eminent while the required precision in the elimination of undesired signals is considerable.

The actual possibilities provided by an A.S.I.C. circuit, do however permit a field lock that extends, as an example, for half of the line time, compensating signals with a precision of more or less 9 nanoseconds.

**Claims**

1. System for ghost compensation in video signals, comprising at least one digital FIR filter and one digital IIR filter, characterised by means for performing a first slow operating mode, in which the filters operate "off-line" on a highly elevated number of coefficients, and means for performing a second "running" operating mode in which the filters operate on a highly reduced number of coefficients, wherein said highly reduced number of coefficients is selected during the first operating mode by means of a coefficient number reducing device (CNRA), which orders off-line the coefficients according to their modulus and copies the most significant ones into running filters which perform the actual filtering of the signal.

2. System according to claim 1, characterised in that said highly elevated number of coefficients is higher than 255, and that said highly reduced number of coefficients is lower that 4.

3. System according to claim 1, characterised in that said system provides a circuit comprising a first branch (forward) comprising an I.I.R. type filter, and a second branch (backward) comprising a F.I.R. type filter.

4. System according to claim 3, characterised in that said I.I.R. type filter, as well as said F.I.R. type filter during said second functioning mode (running) each operate on only three of said appropriately selected coefficients.

5. System according to claim 1, characterised in that said system provides a circuit comprising more F.I.R. type filters.

6. System according to claim 1, characterised in that it is realized at least in an important part, through an A.S.I.C. type integrated circuit.

## Patentansprüche

1. System zur Geisterbild-Kompensation in Videosignalen, aufweisend mindestens ein digitales FIR-Filter sowie ein digitales IIR-Filter, **gekennzeichnet durch** eine Einrichtung zur Ausführen einer langsamen ersten Betriebsart, in welcher die Filter "off-line" mit einer in hohem Grade angehobenen Anzahl von Koeffizienten arbeiten, und eine Einrichtung zum Ausführen einer laufenden zweiten Betriebsart, in der die Filter mit einer in hohem Grade verminderten Anzahl von Koeffizienten arbeiten, wobei die in hohem Grade verminderte Anzahl von Koeffizienten während der ersten Betriebsart mittels einer Koeffizientenanzahl-Reduktionsvorrichtung (CNRA) ausgewählt werden, die off-line die Koeffizienten gemäß ihrem Modulus ordnet und die höchstsignifikanten davon in die laufenden Filter kopiert, welche die tatsächliche Filterung des Signales bewerkstelligen.

2. System nach Anspruch 1, dadurch gekennzeichnet, daß die in hohem Grade angehobene Anzahl von Koeffizienten größer als 255 ist, und daß die in hohem Grade verminderte Anzahl von Koeffizienten kleiner als 4 ist.

3. System nach Anspruch 1, dadurch gekennzeichnet, daß das System eine Schaltung vorsieht, die einen ersten Zweig (vorwärts) mit einem Filter des IIR-Typs sowie einen zweiten Zweig (rückwärts) mit einem Filter des FIR-Typs aufweist.

4. System nach Anspruch 3, dadurch gekennzeichnet, daß das Filter des IIR-Typs sowie das Filter des FIR-Typs während der zweiten Betriebsart (laufend) jeweils mit nur drei der geeignet ausgewählten Koeffizienten arbeitet.

5. System nach Anspruch 1, dadurch gekennzeichnet, daß das System eine Schaltung vorsieht, die weitere Filter des FIR-Typs aufweist.

6. System nach Anspruch 1, dadurch gekennzeichnet, daß es zumindest in einem wichtigen Teil durch eine integrierte Schaltung des ASIC-Typs realisiert ist.

## Revendications

1. Système pour compensation d'image fantôme dans des signaux vidéo, comprenant au moins un filtre à F.I.R. numérique et un filtre à I.I.R. numérique, caractérisé par des moyens pour mettre en oeuvre un premier mode de fonctionnement "lent", dans lequel, les filtres opèrent "autonomes", sur un nombre très élevé de coefficients, et des moyens pour mettre en oeuvre un second mode de fonctionnement "courant", dans lequel les filtres opèrent sur un nombre très réduit de coefficients, dans lequel, ledit nombre très réduit de coefficients est sélectionné durant le premier mode de fonctionnement au moyen d'un dispositif de réduction de nombre de coefficients (CNRA), qui ordonne de façon autonome les coefficients conformément à leurs modules et copie le module le plus significatif dans des filtres courants, qui effectuent la filtration actuelle du signal.

2. Système selon la revendication 1, caractérisé en ce que ledit nombre très élevé de coefficients est supérieur à 255, et en ce que ledit nombre très réduit de coefficients est inférieur à 4.

3. Système selon la revendication 1, caractérisé en ce que ledit système procure un circuit comprenant une première branche (en avant), comprenant un filtre du type à I.I.R., et une seconde branche (en arrière), comprenant un filtre du type à F.I.R.

4. Système selon la revendication 3, caractérisé en ce que ledit filtre du type à I.I.R., aussi bien que ledit filtre du type à F.I.R., durant ledit second mode de fonctionnement "courant", opèrent chacun sur seulement trois desdits coefficients sélectionnés de façon appropriée.

5. Système selon la revendication 1, caractérisé en ce que ledit système procure un circuit comprenant plusieurs filtres du type à F.I.R.

6. Système selon la revendication 1, caractérisé en ce qu'il est réalisé, au moins pour une partie importante, au moyen d'un circuit intégré du type A.S.I.C.

FIG. 1

A(F)

I

F

B(F)

J

F

-J

FIG. 2B

S(F)

FIG. 2A

$H_0(F)$    $A_0$    M    Z(T)

$H_1(F)$    $T_1$    $A_1$

$H_N(F)$    $T_N$    $A_N$

FIG. 3

X(T)    $K_{N+1}(F)$    $K_1(F)$    $T_1$    $A_1$    M    Z(T)

$K_N(F)$    $T_N$    $A_N$

FIG. 4

FIG. 5

SEL (A̅/B)

$R_F(\tau)$ → A/D → B → MUX A

$R_Q(\tau)$ → A/D → MUX

RAM 256 x 8 B
| $R_F(\kappa)$ | $\gamma_F(\kappa-1)$ | $\gamma_F(\kappa-255)$ |

RAM 256 x 8 B
| $R_Q(\kappa)$ | $\gamma_Q(\kappa-1)$ | $\gamma_Q(\kappa-255)$ |

COMPLEX MULTI-PLIER

RAM 256 x 8 B
| $A_F(\kappa-255)$ | $A_F(\kappa)$ | $B_F(\kappa)$ |

COEFFICIENTS UP - DATE

+ → SGN → COMPLEX MULTI-PLIER → SCALER

+ → SGN → SCALER

1Kx8B ROM ITS PHASE

1Kx8B ROM ITS QUADR.

PRESET WAVEFORMS

RAM 256 x 8 B
| $A_Q(\kappa-255)$ | $A_Q(\kappa)$ | $B_Q(\kappa)$ |

+

COMPLEX MULTI-PLIER

$B_F0$

$B_Q0$

ADAPTIVE GAIN CONTROL AND FIR FILTER

$R_F(nT)$ → +

$R_Q(nT)$

+

COMPLEX MULTI-PLIER

RAM 256 x 8 B
RAM 256 x 8 B

ADD 1

$A_F$ 1
$A_Q$ 1

COMPLEX MULTI-PLIER

RAM 256 x 8 B
RAM 256 x 8 B

ADD 2

$A_F$ 2
$A_Q$ 2

COMPLEX MULTI-PLIER

RAM 256 x 8 B
RAM 256 x 8 B

ADD 3

$A_F$ 3
$A_Q$ 3

COEFFICIENTS NUMBER REDUCTION ALGORITHM

(C N R A)

FIG. 6

FIG. 7

EP 0 464 808 B1

FIG. 8